(19) Europäisches Patentamt

European Patent Office

Office européen des brevets

(11) **EP 1 645 662 A1**

(12) **EUROPEAN PATENT APPLICATION**

(43) Date of publication:
**12.04.2006 Bulletin 2006/15**

(51) Int Cl.:
***C25D 7/06*** (2006.01)

(21) Application number: **05256254.3**

(22) Date of filing: **06.10.2005**

| | |
|---|---|
| (84) Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK YU** | (72) Inventor: **Suzuki, Yuuji,**<br>**Furukawa Circuit Foil Co., Ltd.**<br>**Imaichi-city, Tochigi-ken 321-2336 (JP)** |
| (30) Priority: **06.10.2004 JP 2004293785** | (74) Representative: **Feakins, Graham Allan et al**<br>**Raworth Moss & Cook**<br>**Raworth House**<br>**36 Sydenham Road**<br>**Croydon, Surrey CR0 2EF (GB)** |
| (71) Applicant: **FURUKAWA CIRCUIT FOIL CO., LTD.**<br>**Tokyo 101-0054 (JP)** | |

(54) **Surface treated copper foil and circuit board**

(57)    A surface treated copper foil having high frequency characteristics, capable of forming fine pattern and having sufficient peel strength, wherein surface roughness Rz of roughening treated surface made by adhering roughening particles on at least one surface side of untreated copper foil is 0.6 to 1.5 $\mu$m and a brightness value is 35 or smaller; and a circuit board, on which wiring pattern is formed by the same surface treated copper foil, are provided.

**Description**

The present invention relates to a surface treated copper foil suitable to high frequency characteristic, formation of fine pattern and capable of keeping adhesiveness with insulating substrate while repressing the surface roughness, and furthermore relates to a circuit board using the surface treated copper foil.

As electronic equipments getting more compact and lighter, variety of recent electronic devices have become highly integrated.

Composite materials for boards to produce flexible board, high-density mounting multilayer board, and high-frequency circuit board (hereinafter, collectively referred to as circuit board or printed wiring board) are composed of a conductor (copper foil) and an insulating substrate (including film) to support it. The insulating substrate keeps insulation between the conductors and has strength to support the devices.

Also, as signal transmitting speed through the circuit board become faster, intrinsic impedance and signal propagation speed of insulating material composing the circuit board have become more significant, and electroconductivity, dielectric loss and other characteristics of the insulating material are moreover required to be improved.

Phenol resin materials are often used as board material satisfying the above condition, and epoxy resin materials are often used for plating through holes. Also, there are demands for insulating material having smaller electroconductivity and dielectric loss recently because of the high propagation speed of signals, and materials for responding thereto have been under development.

As insulating material for circuit board requires thermostability, thermally stable epoxy resin and polyimide are commonly used. Other than these, dimensionally stable material, material exhibiting less torsion and material exhibiting less thermal shrinkage have been developed.

Furthermore, when thermostability or soldering is required for insulating material for flexible circuit board, polyimide film is used. On the other hand, in other cases such as printing by carbon ink without soldering, a polyester film is used. In recent years, flexible boards have become further complicated and polyimide film has come to be used in many cases.

However, there are disadvantages with polyimide film such as large change of dielectric characteristics when water is absorbed, and wide decline of the high frequency characteristic under a water absorbing environment. Furthermore, while it has high thermostability, it does not have thermally melting property, so that when combining with copper foil conductor, it is necessary to apply such methods as casting polyamic acid as precursor on the copper foil and imidizing it or providing adhesive layer on the polyimide film and laminating the copper foil thereon, etc. These procedures are complicated and disadvantageous.

Liquid crystal polymer and polyetheretherketone have gathered attention as thermoplastic material having thermostability enough to endure soldering and small dielectric characteristics change due to their extremely low hygroscopic property. However, film formed by the liquid crystal polymer or polyetheretherketone based resin exhibits poor adhesiveness with copper foil, and peel strength to copper foil is weaker comparing with that of polyimide.

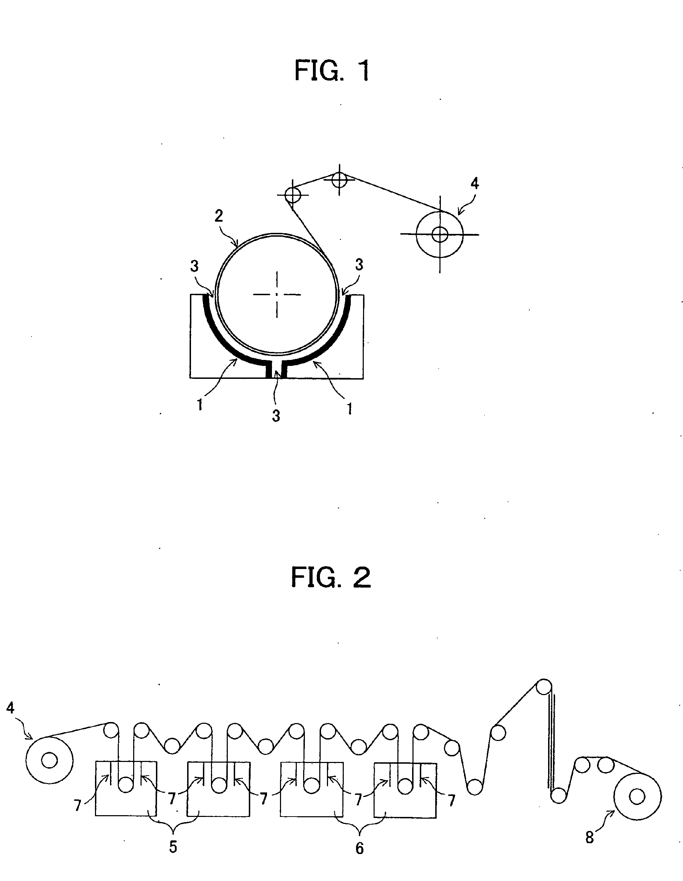

Copper foil adhered to these insulating films to be used as conductive layer is mainly electrodeposited copper foil. Electrodeposited copper foil is normally produced by electrodeposited foil producing device as shown in FIG. 1, and roughening and stain-proof treatment are performed thereon to improve the adhesiveness by surface treatment device as shown in FIG. 2.

The electrodeposited foil producing device shown in FIG. 1 includes a rotating drum-shaped cathode 2 (the surface made of SUS or titanium) and anodes 1 (titanium electrodes coated with precious metal oxide) being concentrically arranged with the cathode, wherein electrolytic solution 3 flows and current flows between the both electrodes to deposit copper to be a predetermined thickness on the cathode surface and, then, the copper is peeled off to be foil shape from the cathode surface.

The copper foil 4 at this stage is an untreated copper foil. The surface contacted with the electrolytic solution 3 is called mat surface and the surface contacted with the rotating drum-shaped cathode 2 is called shiny surface of the untreated copper foil 4.

The produced untreated copper foil 4 is subjected to electrochemical or chemical surface treatment continuously by the surface treatment device as shown in FIG. 2 to improve the adhesive strength (peel strength) required to produce copper-coated multilayer plate (circuit board) by laminating the copper foil on insulating substrate. FIG. 2 shows the device for continuous electrochemical surface treatment, wherein the untreated copper foil 4 continuously passes through electrolytic tanks filled with electrolytic solution 5 and 6. The surface treatment is performed by using electrodes 7 as anodes and the copper foil itself as cathode. Granular copper is deposited on surface of untreated copper foil 4 so as to improve adhesiveness of the bonding with the insulating (resin) substrate. This step is the roughening processing step, which is normally performed on both mat surface and shiny surface of untreated copper foil 4. Copper foil after being subjected to these surface treatments is the surface treated copper foil 8, which is laminated on insulating substrate to produce the circuit board.

Among epoxy resins, polyimides, liquid crystal polymers and polyetheretherketone based resins, the liquid crystal polymers are known as resins with very weak adhesive strength (peel strength) to copper foil. Generally, the peel strength between these resins and copper foil is largely affected by the surface roughness Rz (here, the surface roughness Rz indicates Rz indicated by the ten-score average roughness of 5.1 defined by JISB 0601-1994 "definition and designation for surface roughness") of copper foil. When considering surface roughness of copper foil, surface roughness Rz of untreated copper foil and Rz of treated copper foil obtained by performing the roughening treatment on the copper foil surface are considered. When improving peel strength of smooth untreated copper foil particularly to resins with poor peel strength, method of increasing current flowing at the roughening treatment to increase the amount of granular copper to enhance larger surface roughness Rz has been conventionally applied. It is certain that this method suits to the object of enhancing peel strength, however, for high frequency characteristic, it is not preferable to increase the surface roughness Rz by increased amount of roughening particles with regard to the skin effect.

On the other hand, depending on the kind of liquid crystal polymer films, some film is unable to give correlation to the peel strength even with larger surface roughness Rz of surface treated copper foil. It has been proven that the shape of protrusions on copper foil surface formed by roughening particles is strongly influential to such films.

Furthermore, the circuit pattern on circuit board has been demanded to be higher density and so-called fine pattern printed wiring board, wherein the wiring is formed by circuit pattern formed by fine line width and line pitch, has been developed. Recent case of high-density printed wiring board (circuit board) is formed by extremely fine wiring having line pitch of 50 to 100 $\mu$m and line width of 20 $\mu$m or so. It is also not suitable to increase the surface roughness Rz by larger and/or more adhering amount of roughening particles to enhance higher peel strength in these fine pattern wiring applications as above.

Although, peel strength can be also enhanced by making surface of untreated copper foil rougher and decreasing adhering amount of roughening particles, it is not suitable because the high frequency characteristic is diminished and forming of fine pattern becomes difficult.

Copper foil having improved adhesiveness to liquid crystal polymer film, and copper alloy foil including some specific elements and provided with surface oxidizing layer and stain-proof layer of specific thicknesses have been proposed (for example, refer to the Japanese Unexamined Patent Publication No. 2003-064431). However, when liquid crystal polymer is formed into a film, strength in the thickness direction declines extremely because rodlike molecules orient in the surface direction. Therefore, in such copper foil, the liquid crystal polymer film is easily broken at near the interface with copper foil and as a result, sufficient peel strength cannot be obtained.

Also, other methods such as plasma treatment (for example, refer to the Japanese Unexamined Patent Publication No. 2001-049002) and UV treatment (for example, refer to the Japanese Unexamined Patent Publication No. 2000-233448) on the copper foil surface have been proposed to improve adhesiveness with liquid crystal polymer film. However, even by these methods, sufficient peel strength has not been obtained for copper foil having small surface roughness.

It is desired to provide surface treated copper foil having high frequency characteristic, capable of forming fine pattern, and having sufficient peel strength and circuit board using the foil.

The present invention was made to provide surface treated copper foil having high frequency characteristic, capable of forming fine pattern, and having sufficient peel strength, and a circuit board with it. A surface treated copper foil and a circuit board using the surface treated copper foil have been successfully developed in the present invention which are capable of obtaining sufficient peel strength against epoxy resin substrate and polyimide film generally used as insulating substrates, liquid crystal polymer film with little dielectric characteristics change due to its extremely low hygroscopic property, high thermostability endurable to soldering together with very low peel strength, and polyetheretherketone based substrate and forming fine pattern without increasing roughness on the copper foil surface.

The surface roughened copper foil of the present invention has surface roughness Rz of 0.6 to 1.5 $\mu$m by the roughening treatment applied on at least one surface side of untreated copper foil and surface brightness value of 35 or smaller.

In the present invention, preferably, roughening particles of copper or copper alloy are adhered to the roughening treated surface, and particularly preferably, the amount of copper or copper alloy to be adhered is from 1 mg/dm$^2$ to 160 mg/dm$^2$.

Preferably, on the roughening treated surface of the present invention, projections of the roughening particles are formed so that the height of the projections are 0.3 to 3.0 $\mu$m, and 10 to 100 projections existing 25 $\mu$m length in microscope observation section.

According to the present invention of surface treated copper foil preferably the copper foil before roughening treatment (untreated copper foil) is an electrodeposited copper foil, and the electrodeposited copper foil as the untreated copper foil is formed by granular crystal.

According to the present invention of surface treated copper foil, preferably, the surface roughness Rz of surface to be subjected to surface treatment of the untreated copper foil is 2.0 $\mu$m or less, and more preferably, the surface to be subjected to the roughing treatment is mat surface having surface roughness Rz of 2.0 $\mu$m or less.

Preferably, the projections on the surface treated copper foil of the present invention are formed by Cu particles, particles of alloy of Cu and Mo, or particles of alloy composed of Cu and at least one element selected from group of Ni, Co, Fe, Cr, V and W.

Preferably, the film formed by Ni or Ni alloy is formed at least on surface of the projections on the surface treated copper foil of the present invention, alternately, it is preferable that stain-proof layer composed of zinc layer or zinc alloy layer and/or Cr metal layer or chromate layer is provided at least on surface of the projections on said surface treated copper foil.

Preferably, silane coupling layer is formed at least on the surface of the projections on said surface treated copper foil and/or the stain-proof layer on the surface treated copper foil of the present invention.

The circuit board of the present invention is formed by using the above surface treated copper foil of the present invention.

For a better understanding of the invention and to show how the same may be carried into effect, reference will now be made, by way of example, to the accompanying drawings, in which:-

FIG. 1 is explanatory view of the configuration of an electrodeposited (electrolytic) copper foil producing device;

FIG. 2 is explanatory view of the configuration of a surface treatment device; and

FIG. 3 is schematic section view of circuit board after etching.

In the present invention, copper foil before surface treatment (untreated copper foil) is produced by electrolysis or rolling. Thinner copper foil is preferred in the current pursuit of a finer pattern, however, the rolling costs increase for thinner foil. So, electrodeposited copper foil is preferable.

Thickness of copper foil of 1 to 200 $\mu$m, and copper or copper alloy foil having surface roughness Rz of 0.01 to 2.0 $\mu$m at least on one surface side thereof is preferable.

The reason of setting thickness of copper foil as above is that it is very difficult to perform roughening treatment on surface of copper foil having thickness of less than 1 $\mu$m and foil thicker than 200 $\mu$m is not realistic for high-frequency printed wiring board.

As to the surface roughness of untreated copper foil, foil having Rz of 0.01 $\mu$m or less is realistically hard to be produced. Even if it is produced, the production cost rise sharply and it is not practical. Untreated copper foil having Rz of 2.0 $\mu$m or more can be used, but surface roughness of the untreated copper foil is preferably 2 $\mu$m or less when considering high frequency characteristic and formation of finer pattern.

To obtain copper foil having roughness of 2 $\mu$m or less, columnar crystal may be used but granular crystal is more suitable for suppressing roughness. Also for forming fine pattern granular crystal is more preferable.

Note that all examples of the present invention explained below use copper foil having granular crystal.

This is to obtain adequate adhesiveness to liquid crystal polymer film and high peel strength.

The brightness value was measured by light meter (model name: SM color computer, model number: SM-4 made by SUGA Test Instruments K.K.) after performing a stain-proof treatment on the copper foil to be measured in the ranges below.

Ni: 0.01 to 0.5 mg/dm$^2$

Zn: 0.01 to 0.5 mg/dm$^2$

Cr: 0.01 to 0.3 mg/dm$^2$

The surface treated copper foil of the present invention with surface roughness (Rz) and lightness value as above has excellent peel strength and fine pattern property particularly against liquid crystal polymer film with poor adhesiveness. This is obvious from later explained examples and comparative examples.

In the present invention, as explained above, the surface of untreated copper foil is subjected to roughening treatment, but it is preferable that projections formed by roughening particles are virtually evenly distributed to obtain furthermore excellent peel strength and fine pattern property. Heights of the projections are preferably 0.3 to 3.0 $\mu$m. It is because peel strength cannot be obtained when the height is 0.3 $\mu$m or lower, while it becomes unfavorable for high frequency characteristic and finer pattern when it is 3.0 $\mu$m or higher. Note that the height here indicates a distance from the surface of untreated copper foil to the top of projection.

Also, when the number of projections is small, peel strength is not obtained, while when the number is too large, adhesiveness between the copper foil and the projections becomes poor to adversely diminish the effect, so that 10 to 100 in 25 $\mu$m length in microscopic observation field is preferable, particularly, 20 to 75 is optimal.

The concept of projection in the present invention is, when the distance from bottom of groove formed between adjacent projections to top of the projections (hereinafter, also referred to as a groove depth) is less than 0.01 $\mu$m, such adjacent projections are perceived as one projection, while when the groove depth is 0.01 $\mu$m or more, such adjacent projections are perceived as two projections. The groove depth is distance from bottom of groove to top of projection after the surface roughening treatment, while the height of projection explained above is distance from surface of the untreated copper foil to a top of the projection.

As one of methods to count the number of projections, the surface treated copper foil is covered with resin, polished and observed by SEM on the section to make a picture. The number of projections defined as above in 25 $\mu$m length is counted on the observation picture. In the later explained examples, the number of projections was measured and shown in Table 1 below for each copper foil produced as examples and comparative examples of the present invention by using the above method.

Furthermore, it is preferable that 1600 to 150000 projections having heights of 0.3 to 3.0 $\mu$m exist evenly in a range of 100 $\mu$m x 100 $\mu$m of the roughening treated layer.

Projections existing evenly means that all adjacent projections are within distance of 15 $\mu$m.

Furthermore, preferably 10 to 100 projections exist in 25 $\mu$m length and grooves having depth of 0.2 $\mu$m or more are provided between the projections and virtually evenly distributed for preventing the projections from flocking in the 25 $\mu$m and for stabilizing the peel strength in width and longitudinal direction of copper foil.

Note that "virtually evenly distributed" described here indicates, when assuming observation width of 25 $\mu$m and "n" as the number of projections having heights of 0.3 to 3.0 $\mu$m between tips thereof and the copper foil surface, at least a part of one projection exists in the region obtained by dividing the "n" by the observation length of 25 $\mu$m in the observed area.

Roughening particles forming projections of surface treated copper foil composing board composite material of the present invention are Cu particles, particles of alloy of Cu and Mo, or particles of alloy including at least one kind of element selected from group of Ni, Co, Fe, Cr, V and W in addition to Cu or composition of Cu and Mo.

Desired projections can be obtained by using Cu particles or particles of alloy of Cu and Mo, however, still more evenly distributed projections can be effectively formed by two or more kinds of alloy roughening particles including at least one element selected from a group of Ni, Co, Fe, Cr, V and W in addition to Cu particles or a composition of Cu and Mo..

The roughening particles forming these projections are chemically bonded with resin composing the board and film to increase peel strength. While depending on the kind of resin, as particles to increase the peel strength by chemical bonding, Cu-Mo alloy, Cu-Ni alloy, Cu-Co alloy, Cu-Fe alloy, Cu-Cr alloy, Cu-Mo-Ni alloy, Cu-Mo-Cr alloy, Cu-Mo-Co alloy and Cu-Mo-Fe alloy may be mentioned.

Elements of Ni, Co, Fe, Cr, V and W included in the alloy particles of projections should preferably be 0.01 ppm to 20% of Cu content. It is because when the alloy composition is exceeding 20%, the etching becomes difficult.

In the present invention, to obtain uniformly distributed projections, current density, solution temperature and processing time have to be optimized with variety of electrolytes.

Also, to improve powder falling property, hydrochloric acid resistance, thermostability and conductivity, it is preferable to provide on the surface provided with the projection with metal plating layer of at least one kind selected from group of Ni, Ni alloy, Zn, Zn alloy and Ag. Furthermore, for the purpose of improving hydrochloric acid resistance, thermostability and conductivity, it is preferable to provide also on the surface not provided with the projections with metal plating layer of at least one kind selected from group of Ni, Ni alloy, Zn, Zn alloy and Ag. Preferably, an amount of the adhesive metals serving for the above purpose is 0.05 mg/dm$^2$ to 10 mg/dm$^2$.

Ni or Ni alloy is effective for improving peel strength particularly against the liquid crystal polymer resin.

Then Cr and/or chromate film is formed on the roughening treated surface composed as above, a stain-proof treatment is performed and when required, silane coupling treatment or stain-proof treatment and silane coupling treatment is performed.

For bonding the insulating substrate and the surface roughened copper foil, hot pressing, continuous roll laminating, and a continuous belt pressing are used mostly, which are bonded by thermocompression without an adhesive agent.

The present invention will be explained further in detail based on the following examples, but not limited to them.

[Examples]

For all examples, the copper foil and plating solution for roughening treatment are described below.

(1) Copper Foil

(i) Original Foil 1:

Untreated electrodeposited copper foil and untreated rolled copper foil both having thickness of 12 $\mu$m with matte surface roughness Rz of 0.86 $\mu$m and shiny surface roughness Rz of 1.62 $\mu$m were prepared.

(ii) Original Foil 2:

Untreated electrodeposited copper foil having 12 $\mu$m thickness with matte surface roughness Rz of 1.26 $\mu$m and shiny surface roughness Rz of 1.53 $\mu$m was prepared.

(iii) Original Foil 3:

Untreated electrodeposited copper foil having 2 $\mu$m thickness with matte surface roughness Rz of 1.09 $\mu$m and shiny surface roughness Rz of 1.24 $\mu$m was prepared.

(2) Plating Solution for Surface Roughening Treatment and Plating Condition:

(i) Electroplating A:

* Plating Bath 1

| | |
|---|---|
| Copper sulfate (as Cu metal): | 1 to 10 g/dm$^3$ |
| Sulfic acid: | 30 to 100 g/dm$^3$ |
| Ammonium molybdate (as Mo metal): | 0.1 to 5.0 g/dm$^3$ |
| Current density: | 10 to 60 A/dm$^2$ |
| Current applying time: | 1 to 45 seconds |
| Bath temperature: | 20 to 60°C |

* Plating Bath 2

| | |
|---|---|
| Copper sulfate (as Cu metal): | 20 to 70 g/dm$^3$ |
| Sulfic acid: | 30 to 100 g/dm$^3$ |
| Current density: | 5 to 45 A/dm$^2$ |
| Current applying time: | 1 to 60 seconds |
| Bath temperature: | 20 to 60°C |

(ii) Electroplating B:

* Plating Bath 1

| | |
|---|---|
| Copper sulfate (as Cu metal): | 1 to 50 g/dm$^3$ |
| Nickel sulfate (as Ni metal): | 3 to 25 g/dm$^3$ |
| Ammonium metavanadate (as V metal): | 0.1 to 15 g/dm$^3$ |
| PH: | 1.0 to 4.5 |
| Current density: | 10 to 60 A/dm$^2$ |
| Current applying time: | 5 to 60 seconds |
| Bath temperature: | 20 to 60°C |

* Plating Bath 2

| Copper sulfate (as Cu metal): | 10 to 70 g/dm$^3$ |
|---|---|
| Sulfic acid: | 30 to 120 g/dm$^3$ |
| Current density: | 20 to 50 A/dm$^2$ |
| Current applying time: | 5 to 60 seconds |
| Bath temperature: | 20 to 65°C |
| (iii) Electroplating C: | |

* Plating Bath 1

| Copper sulfate (as Cu metal) : | 1 to 50 g/dm$^3$ |
|---|---|
| Cobalt sulfate (as Co metal): | 1 to 50 g/dm$^3$ |
| Ammonium molybdate (as Mo metal): | 0.1 to 10 g/dm$^3$ |
| PH: | 0.5 to 4.0 |
| Current density: | 10 to 60 A/dm$^2$ |
| Current applying time: | 5 to 60 seconds |
| Bath temperature: | 20 to 60°C |

* Plating Bath 2

| Copper sulfate (as Cu metal): | 10 to 70 g/dm$^3$ |
|---|---|
| Sulfuric Acid: | 30 to 120 g/dm$^3$ |
| Current density: | 5 to 60 A/dm$^2$ |
| Current applying time: | 1 to 60 seconds |
| Bath temperature: | 20 to 65°C |

[Examples]

Examples 1 through 12 were prepared by plating (with roughening treatment) for at least one time on the original foils 1, 2 to 3 in the baths A, B and C in order of bath 1 to 2 with the bath composition, bath temperatures and currents stated above. The surface shapes shown in Table 1 were obtained.

Furthermore, the roughening treated surface was subjected to Ni plating (in amount of 0.3 mg/dm$^2$) and zinc plating (in amount of 0.1 mg/dm$^2$), and additional chromate treatment was performed thereon.

[Table 1]

| Examples of Present Invention | Kind of copper foil | Treated surface | Electro plating bath | Original foil | Treated surface roughness (μm) | Number of projection | Brightness | Film | Peel strength (KN/m) | Reduction rate of Transmission loss (%) | Fine pattern characteristic: minimum values L/S (μm/μm) |
|---|---|---|---|---|---|---|---|---|---|---|---|
| Example 1 | Electrolytic | M | A | 1 | 1.12 | 72 | 22 | Film 1 | 0.51 | 25 | 14/14 |
| Example 2 | Electrolytic | S | B | 3 | 1.85 | 50 | 29 | Film 1 | 0.80 | 28 | 20/20 |
| Example 3 | Rolling | - | B | 1 | 1.25 | 64 | 22 | Film 1 | 0.57 | 18 | 15/15 |
| Example 4 | Electrolytic | M | B | 2 | 1.46 | 58 | 24 | Film 1 | 0.53 | 31 | 15/15 |
| Example 5 | Electrolytic | M | A | 3 | 1.76 | 45 | 28 | Film 1 | 0.74 | 21 | 20/20 |
| Example 6 | Rolling | - | C | 1 | 1.45 | 62 | 25 | Film 1 | 0.61 | 18 | 18/18 |
| Example 7 | Electrolytic | M | B | 2 | 1.35 | 65 | 24 | Film 1 | 0.58 | 17 | 15/15 |
| Example 8 | Electrolytic | S | A | 3 | 1.68 | 51 | 27 | Film 1 | 0.69 | 23 | 18/18 |
| Example 9 | Electrolytic | M | A | 1 | 1.08 | 85 | 21 | Polyimide | 0.48 | 38 | 14/14 |
| Example 10 | Electrolytic | S | B | 3 | 1.75 | 53 | 23 | Polyimide | 0.78 | 25 | 20/20 |
| Example 11 | Electrolytic | M | A | 1 | 1.12 | 76 | 28 | FR4 | 0.47 | 22 | 15/15 |
| Example 12 | Electrolytic | S | B | 3 | 1.86 | 47 | 22 | FR4 | 0.79 | 28 | 20/20 |

[Comparative Example]

Electroplating A', B' and C'

Comparative examples 1 through 12 were prepared by plating (with roughening treatment) for at least one time with the changed condition for current density, time and temperature of the plating bath 2 of the electroplating conditions A, B and C to those of the plating bath 3 (these new baths will be referred to as electroplating A', B' and C', respectively) and in order of bath 1 to 3. Then, in the same way as in the above examples, the treated surface was subjected to Ni plating (0.3 mg/dm$^2$ in amount) and zinc plating (0.1 mg/dm$^2$ in amount), and chromate treatment was performed thereon. The surface shapes of the comparative examples are shown in Table 2.

[Table 2]

| | Kind of copper foil | Treated surface | Electro plating | Original foil | Treated surface roughness (μm) | Number of projection | Brightness | Film | Peel strength (KN/m) | Reduction rate of Transmission loss (%) | Fine pattern characteristic: minimum values L/S (μm/μm) |
|---|---|---|---|---|---|---|---|---|---|---|---|
| Comparative 1 | Electrolytic | M | A' | 1 | 2.52 | 10 | 43 | Film 1 | 0.53 | 0 | 30/30 |
| Comparative 2 | Electrolytic | S | B' | 3 | 3.42 | 6 | 37 | Film 1 | 0.81 | 0 | 50/50 |
| Comparative 3 | Rolling | - | B' | 1 | 2.05 | 2 | 39 | Film 1 | 0.59 | 0 | 25/25 |
| Comparative 4 | Electrolytic | M | B' | 2 | 3.12 | 3 | 38 | Film 1 | 0.55 | 0 | 45/45 |
| Comparative 5 | Electrolytic | M | A' | 3 | 2.78 | 7 | 36 | Film 1 | 0.77 | 0 | 40/40 |
| Comparative 6 | Rolling | - | C' | 1 | 2.38 | 7 | 38 | Film 1 | 0.59 | 0 | 30/30 |
| Comparative 7 | Electrolytic | M | B' | 2 | 2.25 | 0 | 41 | Film 1 | 0.57 | 0 | 25/25 |

| Comparative 8 | Electrolytic | S | A' | 3 | 2.89 | 10 | 37 | Film 1 | 0.76 | 0 | 45/45 |
|---|---|---|---|---|---|---|---|---|---|---|---|
| Comparative 9 | Electrolytic | M | A' | 1 | 2.05 | 3 | 39 | Polyi-mide | 0.49 | 0 | 45/45 |
| Comparative 10 | Electrolytic | S | B' | 3 | 2.43 | 11 | 41 | Polyi-mide | 0.81 | 0 | 30/30 |
| Comparative 11 | Electrolytic | M | A' | 1 | 2.10 | 12 | 36 | FR4 | 0.74 | 0 | 50/50 |
| Comparative 12 | Electrolytic | S | B' | 3 | 3.15 | 5 | 37 | FR4 | 0.76 | 0 | 50/50 |

* Plating Bath 3

| | |
|---|---|
| Copper sulfate (as Cu metal): | 20 to 70 $g/dm^3$ |
| Sulfuric Acid: | 30 to 120 $g/dm^3$ |
| Current density: | 3 $A/dm^2$ |
| Current applying time: | 2 minutes or longer (time is adjusted according to surface roughness) |
| Bath temperature: | 15°C |

Evaluation of Peel Strength of Surface Treated Copper Foil:

[Liquid Crystal Polymer Film]

On the surface treated copper foils produced in the examples and comparative examples, liquid crystal polymer film 1 (hereinafter, referred to as a film 1) was adhered by laminating method explained below, and the peel strength was measured. The results are shown in Table 1 and Table 2.

[Laminating Method of Liquid Crystal Polymer Film and Surface Treated Copper Foil]

The surface treated copper foil and the liquid crystal polymer film 1 are stacked, applied with a certain pressure and held for 10 minutes at 280°C, then, cooled to obtain composite board material.

[Polyimide Film]

After cutting the surface treated copper foils produced as in the examples and comparative examples by 250 mm in length and 250 mm in width, a polyimide film (UPILEX-VT made by UBE Industries Ltd.) of 50 $\mu$m thick was placed on the copper foil surface (roughening surface side), which was sandwiched by flat stainless steel plates, bonded by thermocompression with pressure of 2 $kg/cm^2$ at 330°C for 10 minutes by 20 torr vacuum press, then, bonded by thermocompression with a pressure of 50 $kg/cm^2$ at 330°C for 5 minutes to make composite board material. The peel strength was measured. The measurement results are shown in Table 1 and Table 2.

[Epoxy Resin Substrate]

After cutting the surface treated copper foils produced as in the examples and comparative examples by 250 mm in length and 250 mm in width, the treated surface side was placed on top of a few glass fiber epoxy prepreg sheets (FR-4) to make a thickness of 1 mm after thermocompression, which was sandwiched by flat stainless steel plates, bonded by thermocompression with pressure of 50 $kg/cm^2$ at 170°C for 60 minutes to make FR-4 multilayer board with carrier foil for carrier-peel. The peel strength was measured. The obtained results are shown in Table 1 and Table 2.
Note that the peel strength of composite board material (copper-coated multilayer board) was measured made based on JISC6471 by peeling off in the direction of 180 degree.

Evaluation of High Frequency Transmission Loss:

On the treated copper foils produced as in the examples and comparative examples, glass cloth prepreg impregnated with high frequency substrate resin was placed and subjected to hot pressing to make copper-coated multilayer plate. Next, dry film etching resist was adhered to the copper foil surface and etching was performed to make high-frequency printed wiring board. Linearity of the high-frequency printed circuit was extremely preferable, and high-frequency printed wiring board with wire width of 100 $\mu$m and wire pitch of 200 $\mu$m was obtained. Transmission loss was measured with 5 GHz signal for distance of 500 mm on the high-frequency printed wiring board. Results of reduction rate of transmission loss for each examples and comparative examples are shown in Table 1 and Table 2.
The reduction rate of transmission loss can be obtained from the formula below.

[Formula 1]

Reduction Rate of Transmission Loss (%) =

[Transmission Loss (Example A) - Transmission Loss

(Comparative Example A)] × 100 / (Transmission Loss

(Comparative Example A))

Evaluation of Fine Pattern Characteristics:

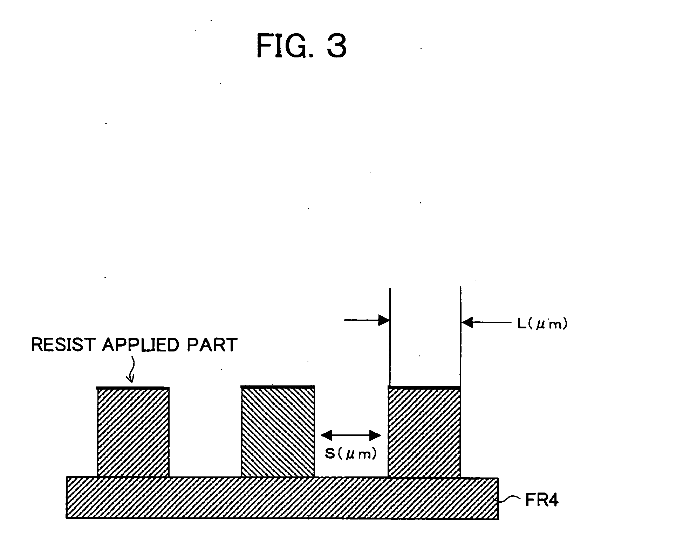

The produced foil was adhered to FR-4 and covered with resist having various line width L and space width S as shown in the schematic sectional view in FIG. 3, was subjected to etching by ferric chloride bath where the etching time was determined to make top line width the same as the resist width. 10 boards with resist having the respective wire width and space width were produced (wherein 10 lines are formed on each board), and etching was performed by ferric chloride bath for the determined time. Each board was checked for defects such as bridge between lines, remaining copper, and width difference of the top lines and the resist lines. Minimum values of L and S among those without the defects, in the produced 10 boards are shown in Table 1 and Table 2.

As is obvious from Table 1 and Table 2, when comparing the surface treated copper foils of examples with comparative examples, despite the small roughness of 2 $\mu$m or less of treated surfaces, the surface treated copper foils of examples exhibit same degree of peel strength as those of the copper foils of the comparative examples (wherein the roughness of the treated surface is as large as 2 $\mu$m or more) due to the number of projections formed by the roughening particles and the lightness (value) depending thereon, and the transmission loss is reduced compared to those of the comparative examples in proportion to the smaller surface roughness. Also, the pattern width can become as fine as 20 $\mu$m / 20 $\mu$m or less.

While it is not shown in Table 1 and Table 2, the same tendency was observed also in the case of polyetheretherketone based resin.

The present invention provides a surface treated copper foil, wherein the surface roughness and the lightness value were suitably adjusted according to the shape of roughening treated surface formed by roughening particles, capable of obtaining peel strength equal to that of rougher surface treated foil even when the surface roughness is small and capable of forming fine wiring pattern.

The surface treated copper foil of the present invention is capable of obtaining sufficient peel strength against board generally hard to obtain adhesive strength to copper foil such as a polyimide film and liquid crystal polymer film, has excellent high frequency characteristic and can provide fine pattern circuit board.

According to the surface treated copper foil of the present invention, surface roughness Rz of 0.6 to 1.5 $\mu$m and the brightness value of 35 or smaller, are the conditions for sufficient peel strength and fine pattern.

Circuit board using the surface treated copper foil of the present invention is capable of providing wiring of particularly fine pattern and excellent high frequency characteristic.

According to the present invention, it is possible to provide surface treated copper foils capable of obtaining peel strength of same degree or stronger than existing ones while keeping the surface roughness smaller in relation to adhesiveness with epoxy resin, polyimide resin, film mainly including thermoplastic liquid crystal polymer and polyetheretherketone based resin. They have an excellent high frequency characteristic and are suitable to attain fine pattern. Furthermore, they can be applied as surface treated copper foil for flexible substrate obtained by stacking the surface treated copper foil and the substrate (film), high-density mounting multilayer substrate and high-frequency circuit board, and applied to circuit board using the surface treated copper foil.

**Claims**

1. A surface treated copper foil, wherein surface roughness Rz of roughening treated surface by adhering roughening particles on at least one surface side of untreated copper foil is 0.6 to 1.5 $\mu$m and brightness value is 35 or smaller.

2. A surface treated copper foil as set forth in claim 1, wherein roughening particles of copper or copper alloy are adhered by 1 mg/dm$^2$ or more and 160 mg/dm$^2$ or less to at least one surface side of the untreated copper foil.

3. A surface treated copper foil as set forth in claim 1 or 2, wherein projections of the roughening particles are formed on surface of the untreated copper foil, heights of the projections are 0.3 to 3.0 $\mu$m, and 10 to 100 of the projections exist in 25 $\mu$m length in observation section.

4. A surface treated copper foil as set forth in any one of claims 1 to 3, wherein the untreated copper foil is electrodeposited copper foil.

5. A surface treated copper foil as set forth in any one of claims 1 to 4, wherein electrodeposited copper foil of untreated copper foil is formed by granular crystal.

6. A surface treated copper foil as set forth in any one of claims 1 to 5, wherein surface roughness Rz of the surface to be subjected to roughening treatment of the untreated copper foil is 2.0 $\mu$m or less.

7. A surface treated copper foil as set forth in any one of claims 1 to 6, wherein surface to be subjected to roughing treatment is matte surface having surface roughness Rz of 2.0 $\mu$m or less.

8. A surface treated copper foil as set forth in any one of claims 1 to 7, wherein projections on said surface treated copper foil are formed by Cu particles, particles of alloy of Cu and Mo, or particles of alloy composed of Cu and at least one element selected from group of Ni, Co, Fe, Cr, V and W.

9. A surface treated copper foil as set forth in any one of claims 1 to 8, wherein film formed by Ni or a Ni alloy is formed on surfaces of the projections on said surface treated copper foil.

10. A surface treated copper foil as set forth in any one of claims 1 to 9, wherein stain-proof layer composed of zinc layer or zinc alloy layer and/or Cr metal layer or chromate layer is provided at least on surfaces of the projections on said surface treated copper foil.

11. A surface treated copper foil as set forth in any one of claims 1 to 10, wherein silane coupling layer is formed at least on surfaces of projections on said surface treated copper foil and/or stain-proof layer.

12. A circuit board, on which wiring pattern is formed by the surface treated copper foil as set forth in any one of claims 1 to 11.

# FIG. 1

# FIG. 2

EP 1 645 662 A1

# FIG. 3

RESIST APPLIED PART

L($\mu$m)

S($\mu$m)

FR4

16

**European Patent Office**

**EUROPEAN SEARCH REPORT**

Application Number

EP 05 25 6254

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| P,X<br>P,A | EP 1 562 413 A (FURUKAWA CIRCUIT FOIL CO., LTD) 10 August 2005 (2005-08-10)<br><br>* claims 1,2,4,6-14 *<br>* examples *<br>* paragraphs [0091], [0092] *<br>----- | 1,2,4-12<br><br>3 | C25D7/06 |
| P,X<br><br><br><br><br>P,A | PATENT ABSTRACTS OF JAPAN<br>vol. 2003, no. 12,<br>5 December 2003 (2003-12-05)<br>-& JP 2005 248323 A (FURUKAWA CIRCUIT FOIL KK), 15 September 2005 (2005-09-15)<br><br>* abstract *<br>----- | 1,12<br><br><br><br><br>3 | |
| X | US 2004/110015 A1 (NARUI KOHJI ET AL) 10 June 2004 (2004-06-10)<br>* paragraphs [0022], [0023], [0027], [0064], [0064] *<br>* examples 1-6 *<br>----- | 1,10-12 | |
| A | US 2004/163842 A1 (OKADA KAZUYUKI ET AL) 26 August 2004 (2004-08-26)<br>----- | 1-12 | **TECHNICAL FIELDS SEARCHED (IPC)**<br>C25D |
| P,A | PATENT ABSTRACTS OF JAPAN<br>vol. 2003, no. 12,<br>5 December 2003 (2003-12-05)<br>-& JP 2005 219379 A (FURUKAWA CIRCUIT FOIL KK; JAPAN GORE TEX INC),<br>18 August 2005 (2005-08-18)<br>* abstract *<br>----- | 1-12 | |

-/--

The present search report has been drawn up for all claims

| Place of search | Date of completion of the search | Examiner |
|---|---|---|
| Munich | 23 January 2006 | Zech, N |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 05 25 6254

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | PATENT ABSTRACTS OF JAPAN vol. 2003, no. 11, 5 November 2003 (2003-11-05) -& JP 2003 201597 A (NIPPON DENKAI KK), 18 July 2003 (2003-07-18) * abstract * * paragraphs [0003], [0005], [0008], [0011], [0014], [0015], [0018] * * examples * ----- | 1,2,4, 7-10 | |
| A | EP 1 452 627 A (FURUKAWA CIRCUIT FOIL CO., LTD) 1 September 2004 (2004-09-01) * paragraphs [0001], [0014] - [0019] * ----- | 1,5-9,11 | |
| T | ANONYMOUS: "Brightness" WIKIPEDIA, [Online] 19 January 2006 (2006-01-19), XP002363866 Retrieved from the Internet: URL:http://en.wikipedia.org/wiki/Brightnes s> [retrieved on 2006-01-23] * the whole document * ----- | 1 | TECHNICAL FIELDS SEARCHED (IPC) |
| T | ANONYMOUS: "Luminosity" WIKIPEDIA, [Online] 2006, XP002363867 Retrieved from the Internet: URL:http://en.wikipedia.org/wiki/Luminosit y> [retrieved on 2006-01-23] * Si photometry units * * abstract * ----- | 1 | |

The present search report has been drawn up for all claims

| Place of search | Date of completion of the search | Examiner |
|---|---|---|
| Munich | 23 January 2006 | Zech, N |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

.......................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 05 25 6254

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2006

| Patent document cited in search report | | Publication date | Patent family member(s) | | Publication date |
|---|---|---|---|---|---|
| EP 1562413 | A | 10-08-2005 | CN<br>US | 1657279 A<br>2005175826 A1 | 24-08-2005<br>11-08-2005 |
| JP 2005248323 | A | 15-09-2005 | NONE | | |
| US 2004110015 | A1 | 10-06-2004 | NONE | | |
| US 2004163842 | A1 | 26-08-2004 | CN<br>WO | 1533686 A<br>03096776 A1 | 29-09-2004<br>20-11-2003 |
| JP 2005219379 | A | 18-08-2005 | NONE | | |
| JP 2003201597 | A | 18-07-2003 | NONE | | |
| EP 1452627 | A | 01-09-2004 | CN<br>US | 1525492 A<br>2004170857 A1 | 01-09-2004<br>02-09-2004 |

EPO FORM P0459

For more details about this annex : see Official Journal of the European Patent Office, No. 12/82